# EUROPEAN PATENT APPLICATION

(11) **EP 4 099 038 A1**
(43) Date of publication of application: **07.12.2022**
(21) Application number: 20938365.2
(22) Date of filing: 30.12.2020
(51) Int. Cl.: G01R 31/382, G01R 31/378

(54) **METHOD FOR PREDICTING AMOUNT OF COATING LAYER FALLING OFF FROM POSITIVE ELECTRODE MATERIAL HAVING COATING LAYER**

(30) Priority: 25.05.2020 CN 202010447540
(71) Applicant: SVOLT ENERGY TECHNOLOGY CO., LTD, Changzhou, Jiangsu 213200 (CN)
(72) Inventor: SUN, Mingzhu, Changzhou, Jiangsu 213200 (CN); JIANG, Weijun, Changzhou, Jiangsu 213200 (CN); QIAO, Qiqi, Changzhou, Jiangsu 213200 (CN); XU, Xinpei, Changzhou, Jiangsu 213200 (CN); SHI, Zetao, Changzhou, Jiangsu 213200 (CN); WANG, Pengfei, Changzhou, Jiangsu 213200 (CN); MA, Jiali, Changzhou, Jiangsu 213200 (CN); CHEN, Sixian, Changzhou, Jiangsu 213200 (CN)
(74) Representative: De Bonis, Paolo
(86) International application number: PCT/CN2020/141190
(87) International publication number: WO 2021/238201

(57) **Abstract**

A method for predicting an amount of coating layer falling off from a positive electrode material having a coating layer, comprising: (1) making a button battery using a positive electrode material, a negative electrode material, a diaphragm and electrolytic solution; (2) obtaining a fully-charged battery by having the button battery go through a charging/discharging cycle; (3) disassembling the fully-charged battery and removing delithiated positive electrode material from the positive electrode sheet; and (4) completely immersing the delithiated positive electrode material in an organic solvent, filtering the delithiated positive electrode material to obtain a filtrate and a filtration residue, and determining the content of a coating element in the filtrate.

## Description

### Technical Field

The present disclosure relates to the field of lithium batteries, for example, to a method for preestimating the shedding amount of the coating layer of the cathode material containing the same.

### Background

With the gradual development and popularization of new energy vehicles, people are paying more attention to the related resources of lithium-ion batteries. The cathode material of high nickel ternary lithium-ion battery has attracted attention due to its higher energy density, but it has shortcomings of easy gas production and poor cycling. In order to improve these problems, coating and co-coating technologies are often used to process the cathode material so as to reduce the direct contact between the cathode material and the electrolyte.

At present, the cathode material of high nickel ternary lithium-ion battery is prone to the problem of shedding of the coating during the charging and discharging processes, resulting in direct contact between the cathode material and the electrolyte, occurrence of side reactions, and deteriorated thermal stability. In the related technologies, the method for testing the shedding of the cathode material is as follows: firstly preparing dozens of kilograms of cathode material, and then performing battery core production for no less than 15 days, thereafter performing formation and capacity grading, followed by performing cycling, it needs to test for 30 days even if according to the fastest cycle, and then disassembling the battery core to check the shedding of the surface coating. This method has the following disadvantages: 1. it requires a large amount of materials and large-scale equipment, and the test cost is high; 2. it takes a long time and often takes several months, which seriously affects the development progress of materials.

Therefore, it is necessary to develop a short-cycle evaluation means to estimate the degree of shedding of the coating, so as to shorten the development cycle of the cathode material and determine the application status of the product.

### Summary

The present disclosure provides a method for preestimating the shedding amount of the coating layer of the cathode material containing the same.

In one embodiment of the present disclosure, a method for preestimating the shedding amount of the coating layer of the cathode material containing the same is provided, and the method comprises:
(1) a fresh cathode material, an anode material, a separator, and electrolyte are made into a button battery; wherein the fresh cathode material is a cathode material containing a coating layer;
(2) the button battery is subjected to 10 to 100 charge-discharge cycles under test conditions of a temperature greater than 30°C, a rate of 0.5C to 4C, and a cut-off voltage greater than 4.2V to obtain a fully charged battery; for example, the temperature is 35°C, 40°C, 45°C, 50°C, 55°C, 60°C, 65°C, 70°C, 75°C or 80°C, etc.; the rate is 0.5C, 1C, 1.5C, 2C, 2.5C, 3C, 3.5C or 4C, etc.; and the cut-off voltage is 4.3V, 4.4V, 4.5V, 4.6V, 4.7V, 4.8V, 4.9V or 5.0V, etc.;
(3) the fully charged battery is disassembled, and the delithiated cathode material on the cathode pole piece is taken out; and
(4) the delithiated cathode material is completely immersed in an organic solvent to obtain a mixed system; the mixed system is filtered to obtain a filtrate and a filter residue, the contents of the main material element(s) and the coating element(s) in the filtrate are measured, and then the shedding amount of the coating layer is determined.

In one embodiment provided in the present disclosure, a cathode material containing a coating layer is made into a button battery for testing. In the present disclosure, in order to accurately evaluate the shedding of the coating layer of the cathode material, the battery is disassembled in a fully charged state, and the delithiated cathode piece obtained by disassembling is immersed in an organic solvent to simulate the direct contact between the cathode material and the electrolyte, the dissolution of the cathode material is accelerated, the test time is shortened, and the shedding of the coating layer of the cathode material is determined by the contents of the main material element(s) and the coating element(s) dissolved in the organic solvent. The test method is simple to operate and no large-scale equipment is required for producing a full battery. The test time is short, and the entire test process requires 3 to 10 days, which is far less than the battery production time of the full battery evaluation scheme. The cost is low, and the test cost is less than 50 Yuan, much lower than the cost of a full battery evaluation. The method effectively shortens the production cycle, cycle period and test period of lithium batteries, and can preestimate the problems such as cycle deterioration, increased gas production, etc., caused by the shedding of the coating of the cathode material during the full battery evaluation.

In one embodiment, in step (2), the test conditions include: a temperature of 30 to 75°C, a rate of 1 to 3C, and a cut-off voltage of 4.2 to 4.6V.

In one embodiment, the organic solvent is at least one selected from the group consisting of dimethyl carbonate, diethyl carbonate, propylene carbonate, and ethylene carbonate.

In one embodiment provided in the present disclosure, in order to accurately evaluate the shedding of the coating layer of the cathode material, the battery is disassembled in a fully charged state in the present disclosure, and the delithiated cathode piece obtained by disassembling is immersed in an organic solvent to simulate the direct contact between the cathode material and the electrolyte, which accelerates the dissolution of the cathode material, shortens the test time, and the shedding of the coating layer of the cathode material is determined by the contents of the main material element(s) and the coating element(s) dissolved in the organic solvent, wherein the organic solvent can be a commonly used lithium battery electrolyte.

In one embodiment, the organic solvent is selected from a combination of propylene carbonate and diethyl carbonate, or a combination of ethylene carbonate and ethyl methyl carbonate.

In one embodiment, the weight ratio of the propylene carbonate to the diethyl carbonate is (0.01-1):1, for example, 0.01:1, 0.1:1, 0.2:1, 0.3:1, 0.4:1, 0.5:1, 0.6:1, 0.7:1, 0.8:1, 0.9:1 or 1:1, etc.

In one embodiment, the weight ratio of the ethylene carbonate to the ethyl methyl carbonate is (0.01-1):1, for example, 0.01:1, 0.1:1, 0.2:1, 0.3:1, 0.4:1, 0.5:1, 0.6:1, 0.7:1, 0.8:1, 0.9:1 or 1:1, etc.

In one embodiment, in step (4), the immersing conditions include: an immersing temperature of 30 to 75°C, an immersing time of 0.5 to 200 hours, for example, an immersing temperature of 30°C, 35°C, 40°C, 45°C, 50°C, 55°C, 60°C, 65°C, 70°C or 75°C, an immersing time of 0.5 hours, 1 hour, 10 hours, 20 hours, 40 hours, 60 hours, 80 hours, 100 hours, 120 hours, 140 hours, 160 hours, 180 hours or 200 hours, etc.

In one embodiment provided by the present disclosure, by immersing at a high temperature for a long time, it is possible to simulate the side reaction between the cathode material and the electrolyte when the battery is used and tested, thereby shortening the test time and improving the accuracy of the evaluation.

In one embodiment, in step (4), the immersing conditions include: an immersing temperature of 50 to 60°C, an immersing time of 10 to 60 hours.

In one embodiment, in step (4), the method for determining the content of the main material elements and the coating elements in the filtrate includes: dissolving the product obtained after drying the filtrate with an acid to obtain a mixed solution, and determining the contents of the main material element(s) and the coating element(s) in the mixed solution.

In one embodiment provided by the present disclosure, the higher the content of the dissolution elements in the filtrate, the greater the chance of contact between the internal materials of the electrode and the electrolyte, that is, the more the shedding of the coating elements in the coating layer of the cathode material. The method provided in the present disclosure is suitable for estimating the shedding of the coating layer of the cathode material containing the same, wherein the coating layer elements include at least one of B, Al, Zr, W, Nb, Mo, Y, La, Ca, Bi, Sn and Zn. The method for testing the contents of the main material element(s) and the coating element(s) in the mixed solution can be known to those skilled in the art, for example, it can be atomic absorption spectrometry, atomic emission spectrometry, ultraviolet-visible spectrophotometry, atomic fluorometry, inductively coupled plasma solution spectrometry (ICP).

In one embodiment, the acid is at least one selected from the group consisting of nitric acid, hydrochloric acid and sulfuric acid.

In one embodiment, the coating element(s) contained in the coating layer is(are) at least one selected from the group consisting of B, Al, Zr, W, Nb, Mo, Y, and La.

In one embodiment, the cathode material is a cobalt-free cathode material.

In one embodiment, the cobalt-free cathode material is a nickel-containing binary lithium ion material.

In one embodiment, the general formula of the nickel-containing binary lithium ion material is LiNiₓMn₁₋ₓO₂, wherein 0.2≤x<1, for example 0.2, 0.3, 0.4, 0.5, 0.6, 0.7, 0.8, 0.9 or 1, etc.

In one embodiment provided by the present disclosure, due to the increase in nickel content, the severity of lithium-nickel mixed arrange increases, and the cobalt in the material can play a role in stabilizing the layered structure of the material, therefore the stability of the cobalt-free material is worse than that of the cobalt-containing material, and the degree of metal dissolution is greater than that of ternary materials.

In one embodiment, the x satisfies 0.7≤x<1, for example 0.7, 0.8, or 0.9, etc.

### Detailed Description of the Embodiments

The technical solutions of the present disclosure will be further described below in conjunction with the drawings and specific embodiments.

In one embodiment, the present disclosure provides a cathode material containing a coating layer. The cathode material is LiNiₓMn₁₋ₓO₂ coated with element B, and the preparation method thereof is as follows:
firstly, lithium hydroxide or lithium carbonate and a precursor NiₓMnₗ₋ₓ(OH)₂ (0.20≤x≤1.0) with a D50 particle size of 0.5 to 4 µm are weighed according to a molar ratio of Li/(Ni+Mn) between 0.95 and 1.10, and uniformly mixed; secondly, the mixture is reacted at a high temperature of 700 to 1000°C for 5 to 15h (air or oxygen), the sintered block material from the reaction is crushed by mechanical mill or jet mill to obtain single crystal particles, most of which have a particle size of 2 to 5 µm. Once again, the previous single crystal particles are coated with boron, and the coated samples and the uncoated samples are treated at a high temperature of 300 to 500°C (a mixture of air, oxygen, nitrogen or argon) for 4 to 10 hours simultaneously. After the high temperature treatment, an uncoated cathode material A₁ and a coated cathode material A₂ (the coating content of boron is 0.01 to 1 wt%) are obtained, respectively.

In one embodiment, the present disclosure provides a method for preparing a button battery, the steps are as follows:
10 g of the above-mentioned cathode material, 10 g of a conductive agent SP, and 10 g of a binder PVDF are taken and put in an oven at 180°C to bake for more than 2 hours; when the ambient humidity is less than 10%, the materials are taken out and placed in a dry environment to cool down; 6.25g of PVDF and 93.75 g of NMP are mixed and stirred for 6 to 9 hours, the produced glue solution is transparent; 4 g of cathode material, 0.174 g of SP, 2.783 g of glue solution are taken, 1 g of NMP is added thereto, and then the materials are homogenized to obtain a cathode slurry; a cleaned steel plate is prepared, and 12 well-cleaned aluminum foil is spreaded, the stirred slurry is poured onto the aluminum foil, and coated on the aluminum foil at an uniform speed, and the coated pole pieces are put into a blast oven at 80°C for oven-drying 20 minutes. The baked pole piece are taken out, the head and tail of the coated pole piece are cut off about 3 cm each, and the cut pole piece is rolled for 3 times, the roll gap is adjusted to 10 µm, and the thickness of the pole piece is pressed to 46 to 48 µm. The coated pole piece is put in an oven at 130°C and oven-dried for more than 5 hours; the dried pole piece is wrapped with a folded weighing paper, and 10 to 15 pole pieces are cut on the cut piece with a Φ14 cutter; the pole pieces are continuously baked in a vacuum oven at 130°C for more than 3 hours. The baked pole pieces are taken out and assembled into a 2032 button battery in a glove box with a water content less than 1 ppm and an oxygen content less than 1 ppm in a way of bottom cover, foam nickel (added with electrolyte), lithium sheet, separator, diaphragm (added with electrolyte) and upper cover.

### Example 1

A method for preestimating the shedding amount of the coating layer of the cathode material containing the same is provided, and the method includes the following steps:
(1) a fresh cathode material A₂ was made into a button battery;
(2) the button battery was subjected to 100 charge-discharge cycles under test conditions of a temperature of 60°C, a rate of 1C, and a test voltage of 3.0 to 4.5V to obtain a fully charged battery;
(3) the fully charged battery was disassembled, and the delithiated cathode material on the cathode pole piece was taken out; and
(4) the delithiated cathode material was completely immersed in an organic solvent (the weight ratio of EC to DMC is 1:1) at 60°C for 50 hours to obtain a mixed system; the mixed system was filtered to obtain a filtrate and a filter residue; the resulting dried product after refluxing and evaporating the filtrate was dissolved in 5 mL of aqua regia, and then diluted to a constant volume of 100 mL; and the contents of the main material elements (Ni and Mn) and the coating element (B) in the diluted mixed solution were tested by the ICP method, the test conditions are shown in Table 1, and the test results are shown in Table 3.

### Example 2

A method for preestimating the shedding amount of the coating layer of the cathode material containing the same is provided, and the method includes the following steps:
(1) a fresh cathode material A₂ was made into a button battery;
(2) the button battery was subjected to 100 charge-discharge cycles under test conditions of a temperature of 50°C, a rate of 0.5C, and a test voltage of 3.0 to 4.2V to obtain a fully charged battery;
(3) the fully charged battery was disassembled, and the delithiated cathode material on the cathode pole piece was taken out; and
(4) the delithiated cathode material was completely immersed in an organic solvent (the weight ratio of EC to DMC is 1:1) at 30°C for 200 hours to obtain a mixed system; the mixed system was filtered to obtain a filtrate and a filter residue; the resulting dried product after refluxing and evaporating the filtrate was dissolved in 5 mL of aqua regia, and then diluted to a constant volume of 100 mL; and the contents of the main material elements (Ni and Mn) and the coating element (B) in the diluted mixed solution were tested by the ICP method, the test conditions are shown in Table 1, and the test results are shown in Table 3.

### Example 3

A method for preestimating the shedding amount of the coating layer of the cathode material containing the same is provided, and the method includes the following steps:
(1) a fresh cathode material A₂ was made into a button battery;
(2) the button battery was subjected to 100 charge-discharge cycles under test conditions of a temperature of 75°C, a rate of 3C, and a test voltage of 3.0 to 4.6V to obtain a fully charged battery;
(3) the fully charged battery was disassembled, and the delithiated cathode material on the cathode pole piece was taken out; and
(4) the delithiated cathode material was completely immersed in an organic solvent (EC) at 75°C for 100 hours to obtain a mixed system; the mixed system was filtered to obtain a filtrate and a filter residue; the resulting dried product after refluxing and evaporating the filtrate was dissolved in 5 mL of aqua regia, and then diluted to a constant volume of 100 mL; and the contents of the main material elements (Ni and Mn) and the coating element (B) in the diluted mixed solution were tested by the ICP method, the test conditions are shown in Table 1, and the test results are shown in Table 3.

### Example 4

A method for preestimating the shedding amount of the coating layer of the cathode material containing the same is provided, and the method includes the following steps:
(1) a fresh cathode material A₂ was made into a button battery;
(2) the button battery was subjected to 10 charge-discharge cycles under the conditions of a temperature of 30°C, a rate of 3C, and a test voltage of 3.0 to 4.5V to obtain a fully charged battery;
(3) the fully charged battery was disassembled, and the delithiated cathode material on the cathode pole piece was taken out; and
(4) the delithiated cathode material was completely immersed in an organic solvent (the weight ratio of EC to DMC is 1:1) at 75°C for 0.5 hours to obtain a mixed system; the mixed system was filtered to obtain a filtrate and a filter residue; the resulting dried product after refluxing and evaporating the filtrate was dissolved in 5 mL of aqua regia, and then diluted to a constant volume of 100 mL; and the contents of the main material elements (Ni and Mn) and the coating element (B) in the diluted mixed solution were tested by the ICP method, the test conditions are shown in Table 1, and the test results are shown in Table 3.

**Table 1**

| | Example 1 | Example 2 | Example 3 | Example 4 |
|---|---|---|---|---|
| Cathode material | Cathode material A₂ | | | |
| Cycle temperature/°C | 60 | 50 | 75 | 30 |
| Cycle rate/C | 1 | 0.5 | 3 | 3 |
| Test voltage/V | 3.0-4.5 | 3.0-4.2 | 3.0-4.6 | 3.0-4.5 |
| Cycle number | 100 | 100 | 100 | 10 |
| Electrolyte | EC+DMC (1:1) | | EC | EC+DMC (1:1) |
| Immersing temperature/°C | 60 | 30 | 75 | 75 |
| Immersing time/h | 50 | 200 | 100 | 0.5 |

### Comparative Example 1

A method for preestimating the shedding amount of the coating layer of the cathode material containing the same is provided, and the method includes the following steps:
(1) a fresh cathode material A₂ was made into a button battery;
(2) the button battery was subjected to 100 charge-discharge cycles under test conditions of a temperature of 60°C, a rate of 1C, and a test voltage of 3.0 to 4.5V to obtain a fully charged battery;
(3) the fully charged battery was disassembled, and the delithiated cathode material on the cathode pole piece was taken out; and
(4) the delithiated cathode material was completely immersed in an organic solvent (the weight ratio of EC to DMC is 1:2) at 60°C for 50 hours to obtain a mixed system; the mixed system was filtered to obtain a filtrate and a filter residue; the resulting dried product after refluxing and evaporating the filtrate was dissolved in 5 mL of aqua regia, and then diluted to a constant volume of 100 mL, the contents of the main material elements (Ni and Mn) and the coating element (B) in the diluted mixed solution were tested by the ICP method, the test conditions are shown in Table 1, and the test results are shown in Table 3.

### Comparative Example 2

A method for preestimating the shedding amount of the coating layer of the cathode material containing the same is provided, and the method includes the following steps:
(1) a fresh cathode material A₂ was made into a button battery;
(2) the button battery was subjected to 100 charge-discharge cycles under test conditions of a temperature of 60°C, a rate of 1C, and a test voltage of 3.0 to 4.5V to obtain a fully charged battery;
(3) the fully charged battery was disassembled, and the delithiated cathode material on the cathode pole piece was taken out; and
(4) the delithiated cathode material was completely immersed in an organic solvent (the weight ratio of EC to DMC is 1:2) at 60°C for 50 hours to obtain a mixed system; the mixed system was filtered to obtain a filtrate and a filter residue; the resulting dried product after refluxing and evaporating the filtrate was dissolved in 5 mL of aqua regia, and then diluted to a constant volume of 100 mL, the contents of the main material elements (Ni and Mn) and the coating element (B) in the diluted mixed solution were tested by the ICP method, the test conditions are shown in Table 1, and the test results are shown in Table 3.

**Table 2**

| | Comparative Example 1 | Comparative Example 2 |
|---|---|---|
| Cathode material | Cathode material A₂ | |
| Test temperature/°C | 20 | 80 |
| Cycle rate/C | 0.2 | 5 |
| Test voltage/V | 3.0-3.8 | 3.0-5 |
| Cycle number | 100 | 100 |
| Electrolyte | EC+DMC | |
| Immersing temperature/°C | 20 | 100 |
| Immersing time/h | 0.2 | 300 |

### Comparative Example 3

A method for estimating the shedding amount of the coating layer of the cathode material containing the same is provided, and the steps are as follows:
(1) the preparation method of the cathode slurry was the same as that of the button battery: 5 kg of the above cathode material was taken and mixed uniformly in the same proportion to prepare a cathode slurry with a solid content of 65%, in which the solvent was NMP; and the slurry was evenly coated on both sides of an aluminum foil with a thickness of 12 Å, dried, and rolled by a roller press to obtain a cathode sheet;
(2) artificial graphite was used as an anode active material, and a mixture of SBR (styrene butadiene rubber) and CMC (sodium carboxymethyl cellulose) was used as a binder, with the mass ratio of SBR to CMC referring to the existing technology; conductive carbon black was used as a conductive agent; the mass ratio of the anode active material to the binder and the conductive agent being 96:3:1, and water was used as a solvent, slurry synthesized to prepare an anode slurry; with the mass fraction of the solvent in the anode slurry being 55%. Then the anode slurry was evenly coated on both sides of a copper foil with a thickness of 8 mm, dried, and rolled by a roller press to obtain an anode sheet;
(3) after die-cutting the prepared cathode sheet and anode sheet, a 16-thick of PP/PE composite separator was used as a separator, laminated into a battery core in an order of cathode sheet, separator, anode sheet, and separator, pressed; and then they were packed into an aluminum-plastic film composite material packaging bag; a non-aqueous electrolyte was poured into the packaging bag, the bag was sealed, and formation was conducted;
(4) the soft-packed battery after formation was placed in a charging and discharging cabinet, and cycled 100 times under the conditions of a cycle temperature of 60°C, a test voltage of 3.0 to 4.5V, and a cycle rate of 1C; and
(5) the fully charged battery core after cycling was taken and disassembled to take out the electrolyte in a battery disassembling room, and the contents of each element in the electrolyte were tested by use of the ICP method. The test results are as shown in Table 3.

### Blank Example 1

The method can be referred to Example 1, except that the cathode material is an uncoated cathode material A₁. The fully charged battery core after cycling was taken and disassembled to take out the electrolyte in a battery disassembling g room, and the contents of each element in the electrolyte were tested by use of the ICP method. The test results are as shown in Table 3.

### Blank Example 2

The method can be referred to Example 1, except that the button battery was not cycled and immersed, and it was disassembled and tested after standing still for 20 days. The test results are as shown in Table 3.

**Table 3**

| | Contents of dissolution elements (mg/kg) | | | Test period/day |
|---|---|---|---|---|
| | Ni | Mn | B | |
| Example 1 | 352 | 79 | 20 | 20 |
| Example 2 | 318 | 62 | 21 | 43 |
| Example 3 | 365 | 65 | 25 | 11 |
| Example 4 | 180 | 40 | 16 | 2 |
| Comparative Example 1 | 80 | 20 | 12 | 18 |
| Comparative Example 2 | 103 | 32 | 14 | 30 |
| Comparative Example 3 | 332 | 72 | 18 | 51 |
| Blank Example 1 | 1206 | 137 | <1 | 20 |
| Blank Example 2 | 12 | 6 | <1 | 20 |

It can be seen from Table 3 that Comparative Example 3 is a method for estimating the metal dissolution of the cathode material containing the coating layer using a full battery. It can be seen from the comparison between Example 1 and Comparative Example 3 that the contents of dissolution elements in Example 1 are equivalent to those in Comparative Example 3, therefore the method provided in the present disclosure can obtain results similar to the full battery test, and at the same time it can greatly shorten the test period (which is shortened to 48 hours, whereas the full battery evaluation takes nearly 2 months).

## Claims

1. A method for preestimating the shedding amount of the coating layer of the cathode material containing the same, comprising:
(1) a fresh cathode material, an anode material, a separator, and electrolyte are made into a button battery; wherein the fresh cathode material is a cathode material containing a coating layer;
(2) the button battery is subjected to 10 to 100 charge-discharge cycles under test conditions of a temperature greater than 30°C, a rate of 0.5C to 4C, and a cut-off voltage greater than 4.2V to obtain a fully charged battery;
(3) the fully charged battery is disassembled, and the delithiated cathode material on the cathode pole piece is taken out; and
(4) the delithiated cathode material is completely immersed in an organic solvent to obtain a mixed system; the mixed system is filtered to obtain a filtrate and a filter residue, the contents of the main material element(s) and the coating element(s) in the filtrate are measured, and then the shedding amount of the coating layer is determined.

2. The method according to claim 1, wherein in step (2), the test conditions comprise: a temperature of 30 to 75°C, a rate of 1 to 3C, and a cut-off voltage of 4.2 to 4.6V.

3. The method according to claim 1 or 2, wherein the organic solvent is at least one selected from the group consisting of dimethyl carbonate, diethyl carbonate, propylene carbonate, and ethylene carbonate.

4. The method according to any one of claims 1 to 3, wherein the organic solvent is selected from a combination of propylene carbonate and diethyl carbonate, or a combination of ethylene carbonate and ethyl methyl carbonate.

5. The method according to claim 4, wherein the weight ratio of the propylene carbonate to the diethyl carbonate is 0.01 to 1:1.

6. The method according to claim 4, wherein the weight ratio of the ethylene carbonate to the ethyl methyl carbonate is 0.01 to 1:1.

7. The method according to any one of claims 1 to 6, wherein in step (4), the immersing conditions comprise: an immersing temperature of 30 to 75°C, and an immersing time of 0.5 to 200 hours.

8. The method according to any one of claims 1 to 7, wherein in step (4), the immersing conditions comprise: an immersing temperature of 50 to 60°C, and an immersing time of 10 to 60 hours.

9. The method according to any one of claims 1 to 8, wherein in step (4), the method for determining the contents of the main material element(s) and the coating element(s) in the filtrate comprises: dissolving the product obtained after drying the filtrate with an acid to obtain a mixed solution, and determining the contents of the main material element(s) and the coating element(s) in the mixed solution.

10. The method according to claim 9, wherein the acid is at least one selected from the group consisting of nitric acid, hydrochloric acid and sulfuric acid.

11. The method according to any one of claims 1 to 10, wherein the coating element(s) contained in the coating layer is(are) at least one selected from the group consisting of B, Al, Zr, W, Nb, Mo, Y, and La.

12. The method according to any one of claims 1 to 11, wherein the cathode material is a cobalt-free cathode material.

13. The method according to claim 12, wherein the cobalt-free cathode material is a nickel-containing binary lithium ion material.

14. The method according to claim 13, wherein the general formula of the nickel-containing binary lithium ion material is LiNiₓMn₁₋ₓO₂, wherein 0.2≤x<1.

15. The method according to claim 14, wherein 0.7≤x<1.
